# FASCICULE DE BREVET EUROPEEN

(11) **EP 0 451 054 B1**
(45) Date de publication et mention de la délivrance du brevet: **10.11.1993**
(21) Numéro de dépôt: 91400908.9
(22) Date de dépôt: 03.04.1991
(51) Int. Cl.: G01R 33/24

(54) **Sonde à RMN compacte**
Kompakte Sonde für die magnetische Kernresonanz
Compact NMR probe

(30) Priorité: 04.04.1990 FR 9004323
(43) Date de publication de la demande: 09.10.1991
(73) Titulaire: COMMISSARIAT A L'ENERGIE ATOMIQUE, 75015 Paris (FR)
(72) Inventeur: Glenat, Henri, F-38700 Corenc (FR); Kernevez, Nelly, F-38000 Grenoble (FR)
(74) Mandataire: Signore, Robert

(56) Documents cités:
- EP-A- 0 206 931
- CA-A- 932 801
- US-A- 3 441 838
- REVUE DE PHYSIQUE APPLIQUEE, vol. 5, no. 1, février 1970, pages 131-134, Paris, FR; A. SALVI: "Perfectionnements apportés aux magnétomètres a résonance magnétique nucléaire a pompage électronique"
- REVUE DE PHYSIQUE APPLIQUEE, vol. 5, no. 1, février 1970, pages 135-140, Paris, FR; R. MIQUEL: "Performances obtenues avec les nouveaux magnétomètres a résonance magnétique nucléaire utilisant la polarisation dynamique par pompage électronique"

## Description

La présente invention a pour objet une sonde à RMN (Résonance Magnétique Nucléaire) compacte. Elle trouve une application dans la mesure précise des champs magnétiques, notamment du champ magnétique terrestre.

La sonde de l'invention est d'un type connu, décrit par exemple dans les demandes de brevet français FR-A-1 447 226 et FR-A-2 098 624.

Le principe de fonctionnement de ces sondes peut être rappelé très brièvement.

Lorsqu'un échantillon liquide, dont les noyaux atomiques ont un moment magnétique et un moment cinétique non nuls, est soumis à un champ magnétique, les moments magnétiques nucléaires ont tendance à s'aligner parallèlement ou antiparallèlement au champ. La différence d'énergie entre ces deux états définit une énergie de résonance nucléaire ou une fréquence de résonance nucléaire, laquelle tombe généralement dans la gamme des basses fréquences (BF), de l'ordre du millier de Hertz.

Cependant, avec les champs habituels et aux températures ordinaires, la polarisation nucléaire globale (positive ou négative) présentée par l'echantillon reste faible et difficilement détectable.

L'effet OVERHAUSER-ABRAGAM permet d'augmenter sensiblement cette polarisation. A cette fin, on dissout une substance paramagnétique appropriée dans un solvant, cette substance étant choisie pour posséder un électron non apparié donnant naissance à un niveau électronique excité présentant une structure hyperfine, à quatre sous-niveaux. En genéral, la fréquence de pompage est située dans la gamme des hautes fréquences (HF), de l'ordre de quelques dizaines de Mégahertz.

Le couplage dipolaire entre le spin électronique de la substance paramagnétique ainsi excitée et le spin nucléaire du solvant augmente considérablement la polarisation de ce dernier. Selon la transition électronique excitée, on favorise la polarisation nucléaire positive ou négative du solvant.

Cette technique est encore perfectionnée par la mise en oeuvre d'un "double effet". Une première solution radicalaire (c'est-à-dire un solvant avec une substance paramagnétique) est soumise à une haute fréquence qui sature le niveau électronique favorisant la polarisation positive du solvant, alors qu'une deuxième solution radicalaire est soumise à une haute fréquence qui sature le niveau électronique favorisant la polarisation négative du solvant.

Dans le premier cas, un signal d'excitation à la fréquence de résonance nucléaire appliqué à l'échantillon sera absorbé par celui-ci alors que, dans le second cas, un signal d'excitation à cette même fréquence provoquera une émission stimulée à la fréquence de résonance. Les enroulements de prélévement disposés autour de la première et de la seconde solutions délivreront alors des tensions de même fréquence mais de phases opposées. Un montage en opposition permettra d'en faire la somme. Tous les signaux parasites induits dans ces enroulements, et qui eux, ont la même phase, seront annulés.

Une telle sonde à double effet peut fonctionner avec deux solutions différentes et une seule fréquence HF d'excitation, à condition que les spectres d'absorption des deux solutions soient décalés l'un par rapport à l'autre de telle sorte que la fréquence unique corresponde à la polarisation positive pour l'un et à la polarisation négative pour l'autre.

Mais une sonde à double effet peut fonctionner aussi avec une même solution répartie en deux échantillons et en appliquant à ces deux échantillons deux fréquences différentes, pour saturer séparément les deux sous-niveaux de la substance paramagnétique.

Enfin, par un dernier perfectionnement, le signal délivré par la sonde, qui est à la fréquence de résonance nucléaire, peut être réinjecté comme signal d'excitation des échantillons, dans un montage en boucle qui fonctionne alors en oscillateur. On obtient alors une sonde du type "oscillateur à couplage de spins et à double effet".

La sonde de l'invention appartient à ce type.

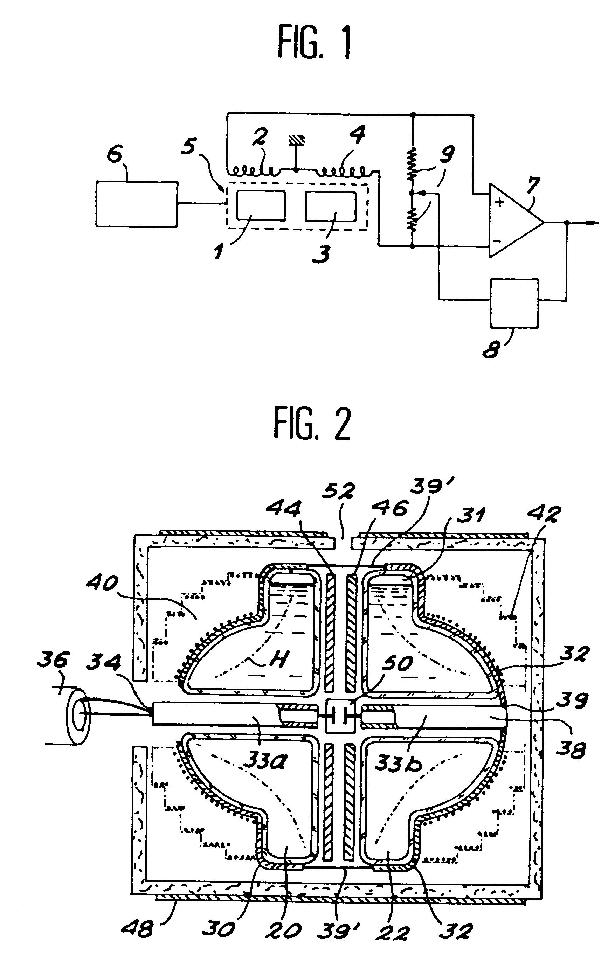

Sur la figure 1 annexée, on voit ainsi une sonde comprenant un premier flacon 1 à polarisation positive avec son enroulement BF 2, un second flacon 3 à polarisation négative avec son enroulement BF 4, un résonateur unique HF 5 entourant les deux flacons et un générateur HF 6 alimentant ce résonateur. Les deux enroulements 2 et 4 sont montés en série-opposition et sont reliés aux entrées positive et négative d'un amplificateur différentiel 7, dont la sortie est rebouclée, par l'intermédiaire d'un régulateur de niveau référencé 8, sur les enroulements BF, le bouclage s'effectuant à travers un pont résistif d'équilibrage 9.

La fréquence du signal délivré par un tel oscillateur est égale à la fréquence de résonance nucléaire, laquelle est directement proportionnelle au champ magnétique ambiant, le facteur de proportionnalité étant égal au rapport gyromagnétique des noyaux atomiques.

La figure 2 illustre de façon plus détaillée la structure d'une telle sonde et la forme des enroulements BF. Ce mode de réalisation est décrit dans le document FR-A-2 583 887.

Telle que représentée, la sonde comprend deux flacons 20, 22 constitués chacun d'un hémisphère et d'une galette cylindrique. Ces deux flacons sont revêtus extérieurement d'une couche métallique argentée, respectivement 30 et 32, divisée en secteurs non jointifs (pour éviter les courants de Foucault circonférentiels). La sonde comprend encore un conducteur central formé de deux demi-tronçons 33a et 33b, l'extrémité gauche 34 du tronçon 33a étant reliée à l'âme centrale d'un coaxial 36 et l'extrémité droite 38 du tronçon 33b étant connectée à la couche conductrice 32 du flacon 22 par des bandes conductrices 39.

La couche conductrice 32 du flacon 22 est reliée à la couche conductrice 30 du flacon 20 par des bandes conductrices 39' comme décrit dans la demande FR-A-2098624, chaque bande conductrice reliant des secteurs appartenant à des flacons distincts.

Les enroulements de prélévement et d'excitation de cette sonde comprennent, d'une part, deux enroulements hémisphériques 40 et 42 extérieurs au résonateur et, d'autre part, deux bobines plates 44 et 46 intérieures au résonateur.

La sonde représentée se complète par un blindage extérieur 48 formé par des bandes métalliques déposées sur un support isolant.

La fréquence de résonance du résonateur est accordée par un condensateur amagnétique 50 disposé entre les tronçons 33a et 33b du conducteur central. Ce condensateur est accessible de l'extérieur grâce à une ouverture 52 pratiquée dans le blindage 48.

Les enroulements hémisphériques 40 et 42 sont obtenus par bobinage sur un gabarit sphérique et imprégnation par une résine. La forme en escaliers présentée par les zones extérieures vient de ce que des spires qui seraient situées dans ces zones participeraient peu à l'excitation et au prélèvement et ont donc été supprimées, ce qui allège d'autant la sonde.

Les enroulements 40 et 42, d'une part, 44 et 46, d'autre part, sont bobinés et connectés de telle sorte que les signaux utiles s'ajoutent et les signaux parasites se retranchent, comme expliqué dans les documents précédemment cités.

La forme particulière donnée aux enroulements de la figure 2 conduit à un champ magnétique d'excitation schématisé par les lignes H. Il résulte de cette forme que, quelle que soit l'orientation de la sonde par rapport au champ à mesurer, il existe toujours un volume de l'échantillon pour lequel le champ d'excitation n'est pas parallèle au champ à mesurer, ce qui évite tout axe interdit de mesure.

Bien que donnant satisfaction à certains égards, une telle sonde présente des inconvénients :
a) Les galettes 44, 46 sont placées dans le résonateur ; elles captent donc fortement le champ HF établi dans celui-ci et le transmettent aux circuits de mesure qui s'en trouvent perturbé.
b) Chaque galette présente un volume nettement inférieur à celui du bobinage principal hémisphérique, le nombre de spires et le diamètre du fil étant inférieurs. Par exemple, le bobinage hémisphérique, peut présenter 2000 spires de fil de diamètre 0,45 mm alors que chaque galette ne comprend que 500 spires de 0,2 mm. Il y a donc là une dissymétrie électrique et une assez forte résistance des enroulements du fait des galettes. Les galettes apportent donc un bruit important et ne participent que peu à la détection du signal.
c) La liaison par bandes ou clinquants 39′ entre les deux flacons, pour fermer le résonateur, est très fragile ; par ailleurs, ces bandes font partie du résonateur, lequel n'est donc pas stable en fréquence, lors de variations de température par exemple, ni reproductible d'une sonde à l'autre.
d) Chaque bloc de la sonde est dissymétrique, peu compact, fragile et non étanche. L'éloignement relatif des deux blocs fragiliserait encore la sonde.

La présente invention a justement pour but de remédier à tous ces inconvénients. A cette fin, elle propose une structure très compacte et symétrique dans laquelle chaque flacon est disposé dans un résonateur qui lui est propre, l'ensemble étant complètement entouré par les bobinages BF, lesquels sont disposés face à face de manière symétrique et connectés entre eux.

Cette disposition de l'invention présente de nombreux avantages à plusieurs points de vue :
a) tenue mécanique : la forme enveloppante des bobinages permet une protection du flacon et rigidifie l'ensemble ; par ailleurs, la liaison par clinquants entre les deux flacons, qui était très fragile, est supprimée ;
b) étanchéité : les bobinages enveloppants rendent la sonde étanche, sauf en ses extrémités, mais l'étanchéité complète est aisément réalisée par des plaques en bout de sonde ;
c) blindage : les bobinages réalisent un blindage vis-à-vis du rayonnement extérieur et vis-à-vis du rayonnement intérieur dû aux résonateurs ;
d) stabilité thermique : la compacité de la sonde et la conductivité thermique des bobinages permet une meilleure homogénéisation de température et une diminution de la dérive thermique lorsque la sonde est soumise à un transitoire thermique ;
e) diminution du bruit : le montage des bobinages en série-opposition, leur accolement et leur alignement suppriment l'effet des champs parasites extérieurs ; le niveau de bruit de la sonde est encore abaissé par la diminution de la résistance des bobinages ;
f) maintien de l'équilibrage électrique : la diminution de l'inductance globale du circuit BF repousse la fréquence d'accord parasite de ce circuit vers les hautes fréquences et permet un meilleur maintien, dans la bande de 1 à 3 kHz, de la symétrie des caractéristiques électriques des deux ensembles de bobinage et, en conséquence, de l'équilibrage réalisé par le pont résistif ;
g) stabilité thermique du résonateur : les dimensions du résonateur sont stables car elles ne dépendent que du flacon et plus, comme dans l'art antérieur, de clinquants de liaison ;
h) minimisation du rayonnement HF : dans la structure de l'invention, il n'y a plus d'enroulement BF dans le résonateur ; il n'y a donc plus de connexion BF à proximité du résonateur, ce qui diminue fortement le rayonnement HF de la sonde ;
i) isotropie d'amplitude : l'amplitude du signal détecté est peu sensible à l'angle entre l'axe de la sonde et la direction du champ mesuré ; cet avantage est primordial pour les applications où le capteur n'est pas à poste fixe ; il est par ailleurs possible de jouer sur le caractère isotrope de la sonde en changeant les nombres relatifs de spires dans chaque couple de bobinages ;
j) isotropie de fréquence : la minimisation du rayonnement HF permet de diminuer l'anisotropie de fréquence de la sonde car ce rayonnement en était la cause essentielle ; la symétrie des deux blocs, en particulier des résonateurs, permet également de diminuer l'anisotropie de fréquence car les circulations de courants continus parasites (dûs à des effets de thermocouple ou redresseur dans le résonateur) sont symétriques et s'annulent en détection ; les symétries sont d'ordre géométrique, électrique, thermique et, si les deux solutions radicalaires sont identiques, physiques ; la forme compacte des flacons et des bobinages (en particulier sphériques) diminue l'anisotropie ; les effets de forme dûs aux éléments para- ou dia-magnétiques sont supprimés ;
k) proximité de deux sondes : avec la version de l'art antérieur, il n'était pas possible de rapprocher deux sondes à une distance inférieure à deux mètres sans qu'apparaisse un phénomène de battement de leur fréquence d'oscillation ; ce battement provenait des rayonnements HF et BF ; en particulier, le champ BF créé par une sonde est capté différemment par les deux flacons de l'autre sonde ; la fréquence de battement est proportionnelle au gradient de ce champ entre les deux flacons ; dans une sonde compacte comme celle de l'invention, le rayonnement HF est diminué et l'alignement des axes des bobinages est suffisamment bien maîtrisé pour que, si l'on place les sondes parallèlement et au même niveau, le gradient BF soit nul entre les deux sondes et qu'il n'y ait plus de battement,
l) chaque bobinage associé au bloc remplit à la fois une fonction de prélèvement et une fonction d'excitation et assure ainsi une symétrie à la fois géométrique et électrique de la sonde.

De façon précise, la présente invention a pour objet une sonde à résonance magnétique nucléaire comprenant au moins deux flacons à solutions radicalaires, l'un à polarisation nucléaire positive, l'autre à polarisation nucléaire négative, au moins un résonateur coaxial haute fréquence et, autour de chaque flacon, un ensemble des bobinages d'excitation-prélévement à basse fréquence, ces ensembles de bobinages étant connectés en série-opposition et reliés à un amplificateur dans un montage oscillateur en boucle, cette sonde étant caractérisée par le fait qu'elle comprend deux blocs ayant une symétrie de révolution par rapport à un axe et une symétrie par rapport à un plan perpendiculaire à l'axe de révolution, chaque bloc comprenant :
- au moins un flacon, ayant une forme de révolution autour de l'axe et symétrique par rapport audit plan de symétrie,
- un résonateur coaxial présentant les mêmes symétries que le flacon et contenant le flacon,
- un double bobinage basse fréquence de révolution autour de l'axe et entourant complétement le résonateur et le flacon et se composant de deux bobinages de révolution placés face à face de part et d'autre dudit plan de symétrie du bloc, ces deux bobinages étant connectés l'un à l'autre.

On rappelle qu'une forme de révolution est engendrée par une courbe tournant autour d'un axe. Si la courbe est un cercle et l'axe un diamètre de ce cercle, on obtiendra une forme sphérique. Si la courbe est un carré et l'axe une diagonale de ce carré, on obtiendra une forme en double cône ou biconique, si l'axe est un axe médian du carré on obtiendra une forme cylindrique, etc...

Selon un mode de réalisation, les deux blocs sont disposés bout à bout, Leurs axes étant confondus.

Selon un autre mode de réalisation, les deux blocs sont disposés côte à côte, leurs axes étant parallèles.

Dans tous ces modes de réalisation, les deux flacons peuvent contenir la même solution radicalaire, les deux résonateurs associés à ces deux flacons devant résonner alors sur deux fréquences différentes correspondant respectivement à une polarisation positive pour l'une des solutions et à une polarisation négative pour l'autre.

Mais dans une autre variante, les deux flacons peuvent contenir des solutions radicalaires différentes, les deux résonateurs associés à ces deux flacons résonnant sur la même fréquence correspondant à une polarisation positive pour l'une des solutions et à une polarisation négative pour l'autre.

Quant aux matériaux pouvant être utilisés pour constituer les solutions radicalaires, elles sont bien connues de l'homme du métier. Les documents cités plus haut, ainsi que EP-A-0 185 825, FR-A-2 063 416 et US-A-3 966 409 les divulguent. Seulement à titre d'exemple, on citera le TANO¹⁵N deutérié dissous dans un mélange de DME (diméthoxyéthane) et d'eau, et le TANO¹⁵N dissous dans le méthanol.

La première solution peut être utilisée dans les deux flacons à condition de régler l'un des résonateurs à 57,6 MHz et l'autre à 58,9 MHz.

La seconde solution peut convenir dans les deux flacons à condition de régler l'un des résonateurs à 58,9 MHz et l'autre à 60,5 MHz.

La première solution peut être employée dans l'un des flacons et la seconde dans l'autre, les deux résonateurs étant accordés à 58,9 MHz.

De préférence, les bobinages sont connectés en série-opposition.

De toute façon, les caractéristiques et avantages de l'invention apparaîtront mieux à la lumière de la description qui va suivre. Cette description porte sur des exemples de réalisation donnés à titre explicatif et nullement limitatif et elle se réfère à des dessins annexés sur lesquels :
- la figure 1, déjà décrite, montre un schéma du montage en oscillateur d'une sonde RMN selon l'art antérieur ;
- la figure 2, déjà décrite, montre, en coupe, la structure d'une sonde de l'art antérieur ;
- la figure 3 illustre une sonde selon l'invention à deux blocs sphériques montés bout à bout ;
- la figure 4 illustre une sonde selon l'invention à deux blocs biconiques montés bout à bout ;
- la figure 5 illustre une sonde selon l'invention à deux blocs cylindriques montés bout à bout ;
- la figure 6 illustre une sonde selon l'invention à deux blocs sphériques montés côte à côte ;
- la figure 7 montre les lignes de champ de détection à l'intérieur des deux bobines montées en série (a) ou en opposition (b) ;
- la figure 8 est un schéma du montage en oscillateur d'une sonde selon l'invention.

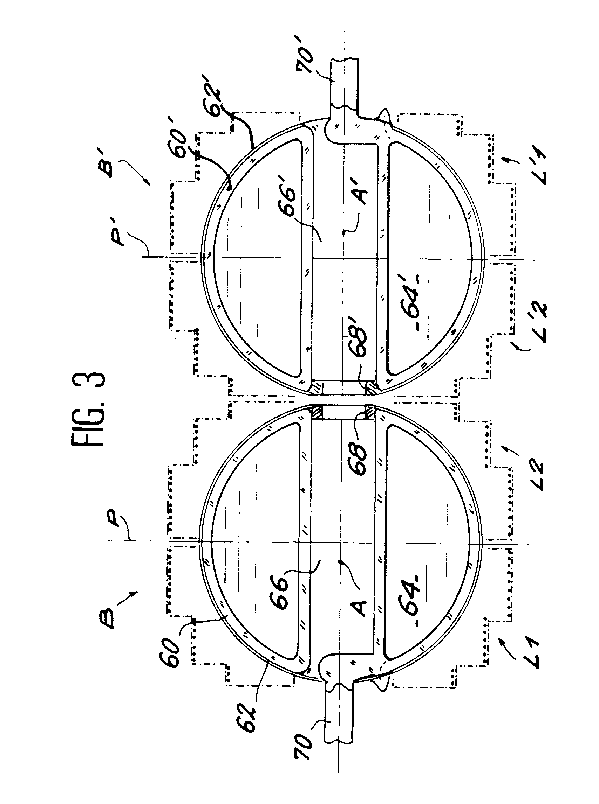

Sur la figure 3, on voit une sonde comprenant deux blocs B et B′ symétriques. Les moyens constituant ces deux blocs portent les mêmes références numériques, celles du bloc B′ étant affectées d'un prime.

Le bloc B (B′) comprend un flacon sphérique 60 (60′), par exemple en verre ou en pyrex, revêtu sur sa face extérieure d'une couche métallique 62 (62'), par exemple en argent, divisée en secteurs. Ce flacon contient un échantillon liquide 64 (64').

Le flacon possède un canal central traversé par un conducteur électrique 66 (66') lequel forme, avec la couche conductrice extérieure 62 (62'), un résonateur. Celui-ci est alimenté en énergie haute fréquence par un câble coaxial 70 (70') relié à un générateur haute fréquence non représenté.

Des condensateurs d'accord 68 (68') sont prévus entre l'extrémité des conducteurs centraux et la couche métallique extérieure.

Chaque flacon est ainsi de révolution autour d'un axe A et est, par ailleurs, symétrique par rapport à un plan P (P') perpendiculaire à cet axe. Chaque flacon est disposé, par construction, à l'intérieur d'un résonateur qui lui est propre (alors que dans l'art antérieur tel qu' i llustré sur la figure 2, les deux flacons se partageaient un même résonateur). Ce résonateur possède les mêmes symétries (de révolution par rapport à l'axe A et par rapport à un plan) que le flacon.

L'ensemble des enroulements basse fréquence est constitué par un double bobinage L1, L2 (L'1, L'2) entourant complétement le flacon et le résonateur. Les deux bobinages de chaque ensemble sont placés face à face, symétriquement par rapport au plan de symétrie P (P') du bloc. Electriquement parlant, ces bobinages ne sont pas nécessairement identiques, comme on le comprendra mieux par la suite, l'un pouvant avoir moins de spires que l'autre et utiliser un fil de diamètre plus faible que l'autre.

Quoi qu'il en soit, ces enroulements peuvent être connectés en série-opposition, c'est-à-dire que le courant qui les traverse circule en sens contraire dans les deux bobinages (par opposition à un montage série-série où les courants circuleraient dans le même sens).

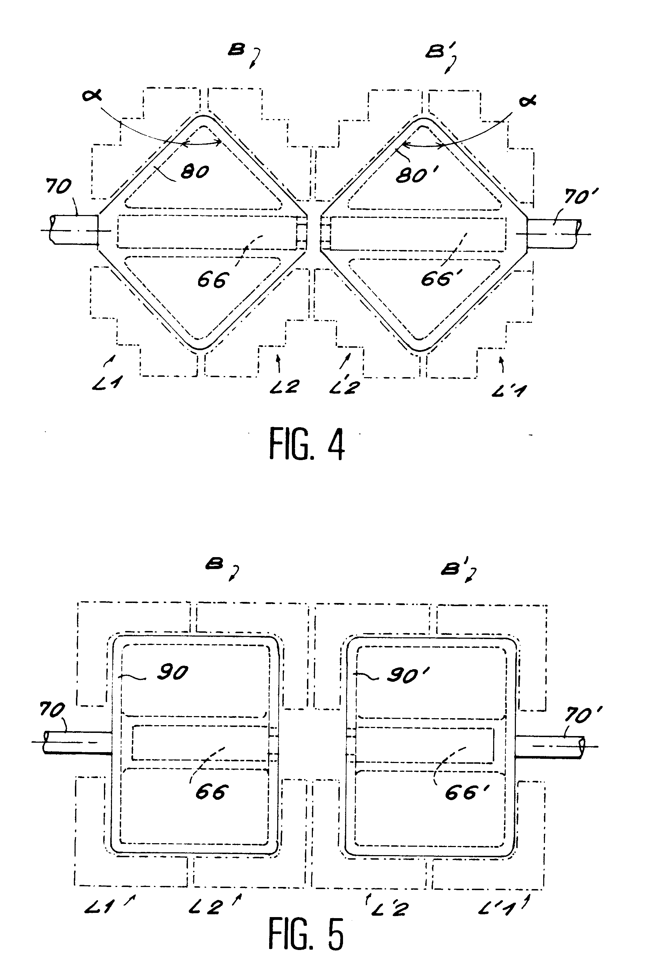

La figure 4 montre un autre exemple de réalisation dans lequel le flacon 80 (80′) et le conducteur extérieur du résonateur ont une forme torique de section triangulaire. L'intérêt de cette forme est que l'on peut jouer sur l'isotropie de la sonde en choisissant une valeur convenable de l'angle α du flacon (figure 4).

La figure 5 montre encore un autre exemple de réalisation dans lequel les flacons et le conducteur externe du résonateur ont une forme cylindrique.

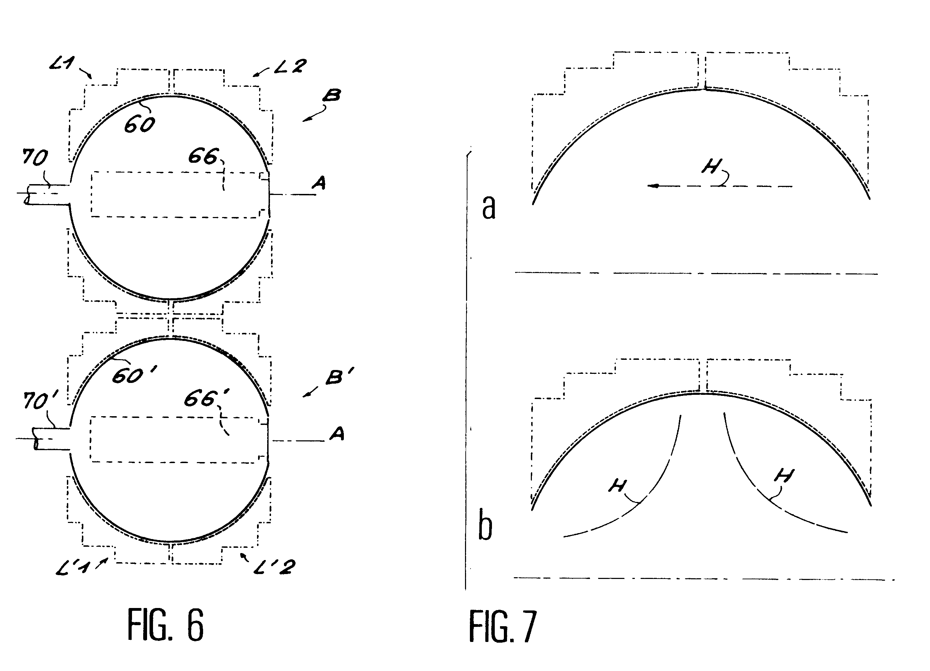

La figure 6 montre une variante dans laquelle les deux blocs B et B′, au lieu d'être disposés bout à bout comme sur les figures 3 à 5, sont placés côte à côte, leurs axes A et A′ étant parallèles.

La figure 7 permet de souligner l'intérêt de la connexion série-opposition des deux bobinages relatifs à un même flacon. Sur la partie (a) de la figure 7, on a supposé que les deux bobinages étaient connectés en série-série. Dès lors, l'ensemble se comporte comme un seul bobinage et les lignes H du champ de détection sont parallèles à l'axe. Si le champ à mesurer vient à être, lui aussi, parallèle à cet axe, aucune zone de l'échantillon ne sera soumise à un champ de prélèvement non parallèle au champ à mesurer (ce qui est la condition nécessaire de fonctionnement d'une sonde à RMN). Il y aura donc un axe interdit de mesure pour la sonde : l'axe même de celle-ci. Néanmoins, le montage série-série peut être avantageux dans le cas où la sonde est fixe et orientable par rapport au champ de façon à placer la sonde selon un axe perpendiculaire à l'axe interdit. Ce montage particulier permet d'avoir une amplitude du signal de sortie plus importante.

Avec un branchement série-opposition, comme illustré sur la partie (b) de la figure 7, les lignes H du champ de prélèvement sont incurvées ; quelle que soit la direction du champ à mesurer, il y a toujours une zone de l'échantillon qui sera soumise à un champ non parallèle au champ à mesurer : il n'y a plus d'axe interdit.

Par ailleurs, en jouant sur la structure des deux bobinages L1, L2, on peut encore réduire la légère anisotropie qui subsiste, comme les deux exemples suivants vont mieux le faire comprendre.

### Exemple 1

Tous les bobinages L1, L2, L′1, L′2 ont le même nombre de spires (1325) et le même diamètre de fil (0,475 mm). Deux cas sont à comparer :
a) pour des bobinages qui seraient montés en série-série (ce qui est le cas de l'invention dans la variante de la figure 7a), pour un champ magnétique parallèle à l'axe, le signal de mesure serait nul, alors que, pour un champ perpendiculaire à l'axe, le signal serait de 6,18 (en microvolts efficace) ; l'anisotropie serait donc infinie, conformément aux explications données à propos de la figure 7a.
b) pour des bobinages montés en série-opposition (selon la fig. 7b), le signal obtenu avec un champ parallèle à l'axe est de 4,26 et de 3,66 avec un champ perpendiculaire à l'axe ; l'anisotropie est donc de (4,26-3,66)/4,26 soit 14%.

### Exemple 2

Les bobinages opposés L1, L′1 comprennent 1900 spires de fil de diamètre 0,40 mm et les bobinages accolés L2, L′2 ont 1325 spires de 0,475 mm. Dans le montage série-opposition, avec un champ parallèle à l'axe, le signal de mesure est de 4,34 alors qu'avec un champ perpendiculaire à l'axe le signal est de 4,49 ; l'anistropie est tombée à 3%.

On observe ainsi une propriété surprenante de la sonde de l'invention selon laquelle, malgré une structure privilégiant hautement un axe (l'axe de révolution), une isotropie quasi-parfaite est obtenue. Cette propriété est obtenue grâce au montage série-opposition et au choix judicieux du nombre de spires des couples de bobinages.

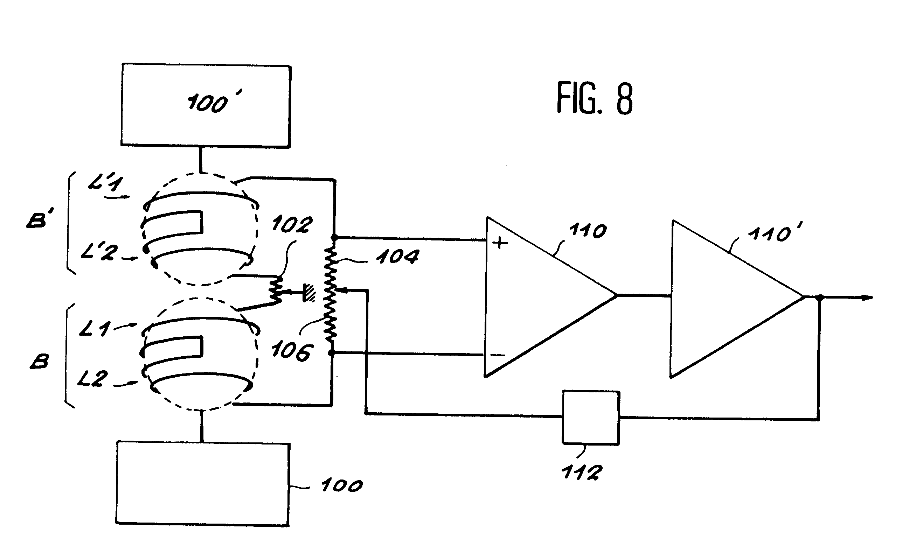

La figure 8 enfin, montre le schéma du montage en oscillateur d'une sonde selon l'invention. Les bobinages L1, L2 du bloc B ainsi que les bobinages L′1, L′2 du bloc B′ sont montés par exemple en série-opposition dans chaque bloc, comme déjà expliqué. Par ailleurs, les deux doubles bobinages (L1, L2), (L′1, L′2) sont eux-mêmes montés en série-opposition à travers une résistance 102 reliée à la masse en son point milieu. Les extrémités libres des deux doubles bobinages sont reliées à travers un pont de résistances 104, 106. Ce pont est, par ailleurs, connecté aux entrées d'un amplificateur différentiel linéaire 110 suivi éventuellement d'un autre amplificateur 110′ ; la sortie amplifiée est rebouclée sur le pont 104, 106 en un point réglable permettant d'obtenir un équilibrage. Deux générateurs HF 100 et 100′ alimentent les deux résonateurs indépendants des deux blocs. La sortie amplifiée constitue la sortie S de la sonde. La fréquence du signal disponible sur S est directement proportionnelle à l'intensité du champ magnétique ambiant.

L'invention qui vient d'être décrite peut être mise en oeuvre avec un nombre quelconque d'échantillons et avec tous les noyaux atomiques connus en RMN (protons ou autres).

## Revendications

1. Sonde à résonance magnétique nucléaire comprenant au moins deux flacons (60,60';80,80';90;90') à solutions radicalaires, l'un (60;80;90) à polarisation nucléaire positive, l'autre (60';80';90') à polarisation nucléaire négative, au moins un résonateur coaxial haute fréquence (62,66;62',66') et, autour de ces flacons (60,60';80,80';90,90'), des ensembles de bobinages d'excitation-prélèvement à basse fréquence (L1,L2;L'1,L'2), ces ensembles étant reliées en série-opposition, un amplificateur (110) à deux entrées reliées auxdits ensembles de bobinage et à une sortie rebouclée sur lesdits ensembles de bobinage, un flacon (60,60';80,80';90,90') et son ensemble de bobinages d'excitation-prélèvement (L1,L2;L'1,L'2) formant chacun un bloc (B, B') ayant une symétrie de révolution par rapport à un axe (A, A'),
cette sonde étant caractérisée en ce que :
- chaque bloc (B, B') présente en outre une symétrie par rapport à un plan (P, P') perpendiculaire à l'axe de révolution,
- un résonateur coaxial haute fréquence (62, 66), (62', 66') est disposé autour de chaque flacon et présente une symétrie de révolution autour de l'axe et une symétrie par rapport audit plan (P, P') perpendiculaire à l'axe de révolution,
- chaque ensemble de bobinages d'excitation-prélèvement (L1, L2), (L'1, L'2) entoure complétement le résonateur et le flacon et se compose de deux bobinages (L1, L2), (L'1, L'2) de révolution placés face à face de part et d'autre dudit plan (P, P') de symétrie du bloc, ces deux bobinages étant connectés l'un à l'autre.

2. Sonde selon la revendication 1, caractérisée par le fait que la forme de révolution des blocs (B, B'), flacons (60, 60'), résonateurs (62, 66; 62', 66'), doubles bobinages (L1, L2), (L'1, L'2) est sphérique.

3. Sonde selon la revendication 1, caractérisée par le fait que la forme de révolution des blocs (B, B'), flacons (80, 80'), résonateurs (62,66;62',66'), doubles bobinages (L1, L2), (L'1, L'2) est biconique.

4. Sonde selon la revendication 1, caractérisée par le fait que la forme de révolution des blocs (B,B'), flacons (90, 90'), résonateurs (62,66;62';66'), doubles bobinages (L1, L'1), (L2, L'2) est cylindrique.

5. Sonde selon la revendication 1, caractérisée par le fait que les deux blocs (B, B') sont disposés bout à bout, leurs axes (A, A') étant confondus.

6. Sonde selon la revendication 1, caractérisée par le fait que les deux blocs (B, B') sont disposés côte à côte, leurs axes (A, A') étant parallèles.

7. Sonde selon la revendication 1, caractérisée par le fait que les deux flacons (60,60';80,80';90,90') contiennent la même solution radicalaire (64, 64'), les deux résonateurs (62, 66 ; 62', 66') associés à ces deux flacons (60, 60';80,80';90,90') résonant sur deux fréquences différentes correspondant respectivement à une polarisation nucléaire positive pour l'une des solutions et à une polarisation nucléaire négative pour l'autre.

8. Sonde selon la revendication 1, caractérisée par le fait que les deux flacons (60,60';80,80';90,90') contiennent des solutions radicalaires différentes, les deux résonateurs (62, 66 ; 62', 66') associés à ces deux flacons (60,60';80,80';90,90') résonnant sur la même fréquence correspondant à une polarisation nucléaire positive pour l'une des solutions et à une polarisation nucléaire négative pour l'autre.

9. Sonde selon la revendication 1, caractérisée par le fait que les deux bobinages (L1, L2), (L'1, L'2) d'un même bloc (B, B') sont connectés l'un à l'autre en série-opposition.

10. Sonde selon la revendication 1, caractérisée par le fait que les deux bobinages (L1, L2), (L'1, L'2) d'un même bloc ont des nombres de spires différents.

## Patentansprüche

1. Sonde für die magnetische Kernresonanz, die wenigstens zwei Fläschchen (60, 60'; 80, 80'; 90, 90') für radikalische Lösungen - eines (60; 80; 90) für positive Kernpolarisation, das andere (60'; 80', 90') für negative Kernpolarisation -, einen Hochfrequenz-Koaxialresonator (62, 66; 62', 66') sowie, um diese Fläschchen (60, 60'; 80, 80'; 90, 90') herum, Anordnungen von Wicklungen zur Anregung und Signalentnahme bei niedriger Frequenz (L1, L2; L'1, L'2), wobei diese Anordnungen gegenphasig in Serie geschaltet sind, und einen Verstärker (110) mit zwei Eingängen, die mit den Anordnungen von Wicklungen verbunden sind, und mit einem Ausgang, der auf genannte Anordnungen von Wicklungen zurückgeschleift ist, umfaßt, wobei ein Fläschchen (60, 60'; 80, 80'; 90, 90') und seine Anordnung von Wicklungen zur Anregung und Signalentnahme (L1, L2; L'1, L'2) jeweils einen Block (B, B') bildet, der eine Drehsymmetrie in Bezug auf eine Achse (A, A') hat, wobei diese Sonde dadurch gekennzeichnet ist, daß
- jeder Block (B, B') ferner eine Symmetrie in Bezug auf eine zur Drehachse senkrechte Ebene (P, P') besitzt,
- um jedes Fläschchen herum ein Hochfrequenz-Koaxialresonator (62, 66), (62', 66') angebracht ist, der eine Drehsymmetrie um die Achse und eine Symmetrie in Bezug auf genannte, zur Drehachse senkrechte Ebene (P, P') besitzt,
- jede Anordnung von Wicklungen zur Anregung und Signalentnahme (L1, L2), (L'1, L'2) vollständig den Resonator und das Fläschchen umgibt und aus zwei Drehwicklungen (L1, L2), (L'1, L'2) zusammengesetzt ist, die auf beiden Seiten genannter Ebene (P, P') einander gegenüber angeordnet sind, wobei diese beiden Wicklungen miteinander verbunden sind.

2. Sonde nach Anspruch 1, durch die Tatsache gekennzeichnet, daß die Drehungsform der Blöcke (B, B'), Fläschchen (60, 60'), Resonatoren (62, 66; 62', 66'), zwei Wicklungen (L1, L2), (L'1, L'2) sphärisch ist.

3. Sonde nach Anspruch 1, durch die Tatsache gekennzeichnet, daß die Drehungsform der Blöcke (B, B'), Fläschchen (80, 80'), Resonatoren (62, 66; 62', 66'), zwei Wicklungen (L1, L2), (L'1, L'2) bikonisch ist.

4. Sonde nach Anspruch 1, durch die Tatsache gekennzeichnet, daß die Drehungsform der Blöcke (B, B'), Fläschchen (90, 90'), Resonatoren (62, 66; 62', 66'), zwei Wicklungen (L1, L2), (L'1, L'2) zylindrisch ist.

5. Sonde nach Anspruch 1, durch die Tatsache gekennzeichnet, daß die zwei Blöcke (B, B') Spitze an Spitze angeordnet sind, wobei ihre Achsen zusammenfallen.

6. Sonde nach Anspruch 1, durch die Tatsache gekennzeichnet, daß die zwei Blöcke (B, B') Seite an Seite angeordnet sind, wobei ihre Achsen parallel sind.

7. Sonde nach Anspruch 1, durch die Tatsache gekennzeichnet, daß die zwei Fläschchen (60, 60'; 80, 80'; 90, 90') dieselbe radikalische Lösung (64, 64') enthalten, wobei die zwei den Fläschchen (60, 60'; 80, 80'; 90, 90') zugeordneten Resonatoren (62, 66; 62', 66') mit zwei unterschiedlichen Frequenzen schwingen, die einer positiven Kernpolarisation für die eine der Lösungen beziehungsweise einer negativen Kernpolarisation für die andere entsprechen.

8. Sonde nach Anspruch 1, durch die Tatsache gekennzeichnet, daß die zwei Fläschchen (60, 60'; 80, 80'; 90, 90') verschiedene radikalische Lösungen enthalten, wobei die zwei den Fläschchen (60, 60'; 80, 80', 90, 90') zugeordneten Resonatoren (62, 66; 62', 66') mit gleicher Frequenz schwingen, die einer positiven Kernpolarisation für die eine der Lösungen und einer negativen Kernpolarisation für die andere entspricht.

9. Sonde nach Anspruch 1, durch die Tatsache gekennzeichnet, daß die zwei Wicklungen (L1, L2), (L'1, L'2) ein und desselben Blocks (B, B') miteinander gegenphasig in Serie verbunden sind.

10. Sonde nach Anspruch 1, durch die Tatsache gekennzeichnet, daß die zwei Wicklungen (L1, L2), (L'1, L'2) ein und desselben Blocks verschiedene Windungszahlen haben.

## Claims

1. Nuclear magnetic resonance probe incorporating at least two bottles (60, 60'; 80, 80'; 90, 90') with radical solutions, one (60, 80, 90) having a positive nuclear polarization and the other (60', 80', 90') having a negative nuclear polarization, at least one high frequency, coaxial resonator (62, 66; 62', 66') and around each of the said bottles (60, 60'; 80, 80', 90, 90'), assemblies of low frequency, exciting-sampling coils (L1, L2; L'1, L'2), said assemblies being connected in series-opposition, an amplifier (110) having two inputs connected to said coil assemblies and to an output relooped on said coil assemblies, a bottle (60, 60'; 80, 80', 90, 90') and its exciting-sampling coil assembly (L1, L2, L'1, L'2) forming in each case a block (B, B') having a symmetry of revolution relative to an axis (A, A'), said probe being characterized in that:
each block (B, B') also has a symmetry relative to a plane (P, P') perpendicular to the axis of revolution,
a high frequency, coaxial resonator (62, 66, 62', 66') being located around each bottle and having a symmetry of revolution about the axis and a symmetry relative to said plane (P, P') perpendicular to the axis of revolution, each assembly of exciting-sampling coils (L1, L2; L'1, L'2) completely surrounds the resonator and the bottle and is constituted by two coils (L1, L2; L'1, L'2) of revolution positioned facing one another on either side of the said plane (P, P') of symmetry of the block, said two coils being connected to one another.

2. Probe according to claim 1, characterized in that the shape of revolution of the blocks (B, B'), bottles (60, 60'), resonators (62, 66; 62', 66') and double coils (L1, L2; L'1, L'2) is spherical.

3. Probe according to claim 1, characterized in that the shape of revolution of the block (B, B'), bottles (80, 80'), resonators (62, 66; 62', 66') and double coil (L1, L2; L'1, L'2) is biconical.

4. Probe according to claim 1, characterized in that the shape of revolution of the blocks (B, B'), bottles (90, 90'), resonators (62, 66; 62', 66') and double coils (L1, L'1; L2, L'2) is cylindrical.

5. Probe according to claim 1, characterized in that the two blocks (B, B') are positioned end to end, their axes (A, A') being parallel.

6. Probe according to claim 1, characterized in that the two blocks (B, B') are placed side by side, their axes (A, A') being parallel.

7. Probe according to claim 1, characterized in that the two bottles (60, 60'; 80, 80'; 90, 90') contain the same radical solution (64, 64'), the two resonators (62, 66; 62', 66') associated with these two bottles (60, 60'; 80, 80'; 90, 90') resonating on two different frequencies respectively corresponding to a positive nuclear polarization for one of the solutions and a negative polarization solution for the other.

8. Probe according to claim 1, characterized in that the two bottles (60, 60'; 80, 80'; 90, 90') contain different radical solutions, the two resonators (62, 66; 62', 66') associated with these two bottles (60, 60'; 80, 80'; 90, 90') resonating on the same frequency corresponding to a positive nuclear polarization for one of the solutions and a negative nuclear polarization for the other.

9. Probe according to claim 1, characterized in that the two coils (L1, L2; L'1, L'2) of the same block (B, B') are connected to one another in series-opposition.

10. Probe according to claim 1, characterized in that the two coils (L1, L2; L'1, L'2) of the same block have different numbers of turns.
